# EUROPEAN PATENT APPLICATION

(11) **EP 4 597 806 A1**
(43) Date of publication of application: **06.08.2025**
(21) Application number: 22960892.2
(22) Date of filing: 29.09.2022
(51) Int. Cl.: H02K 11/33

(54) **ROTARY ELECTRIC MACHINE AND METHOD FOR MANUFACTURING SAME**

(71) Applicant: Mitsubishi Electric Mobility Corporation, Tokyo 100-8310 (JP)
(72) Inventor: SUZUKI, Junya, Tokyo 100-8310 (JP); ONISHI, Yoshihiko, Tokyo 100-8310 (JP); SONODA, Isao, Tokyo 100-8310 (JP)
(74) Representative: Hoffmann Eitle
(86) International application number: PCT/JP2022/036342
(87) International publication number: WO 2024/069830

(57) **Abstract**

A rotary electric machine includes a motor including a rotary shaft, and a control unit that controls the motor, in which the control unit includes a substrate unit that includes a first circuit substrate, a second circuit substrate, and a holding member that is disposed between the first circuit substrate and the second circuit substrate and holds the first circuit substrate and the second circuit substrate, a heat sink that is disposed between the motor and the substrate unit and faces the first circuit substrate in an axial direction of the rotary shaft, and a fastening member that fixes the substrate unit to the heat sink, the holding member includes a base portion, a first locking portion that is connected to the base portion and locks the first circuit substrate from a second surface of the first circuit substrate on a side opposite to a first surface of the first circuit substrate facing the base portion, and a second locking portion that is connected to the base portion and locks the second circuit substrate from a fourth surface of the second circuit substrate on a side opposite to a third surface of the second circuit substrate facing the base portion, and the fastening member penetrates the substrate unit in the axial direction and is fastened to the heat sink.

## Description

### Technical Field

The present disclosure relates to a rotary electric machine and a method for manufacturing the same.

### Background Art

A rotary electric machine disclosed in Patent Document 1 includes a motor including a rotary shaft and a control unit that controls the motor. The control unit includes a first circuit substrate and a second circuit substrate that are disposed in a row in an axial direction of the rotary shaft, a spacer that is provided between the first circuit substrate and the second circuit substrate, and a connector assembly that is connected to the first and second circuit substrates. During manufacturing of the rotary electric machine, the connector assembly, the second circuit substrate, the spacer, and the first circuit substrate are disposed in this order in the axial direction, and a common fixing member is inserted through the connector assembly, the second circuit substrate, the spacer, and the first circuit substrate. By fixing an end portion of the common fixing member to a heat sink, the connector assembly, the second circuit substrate, the spacer, and the first circuit substrate are fixed to the heat sink.

### Citation List

### Patent Documents

Patent Document 1: Japanese Unexamined Patent Application, First Publication nO. 2020-127334

### Summary of Invention

### Problem to be Solved by the Invention

In a structure of Patent Document 1, the first circuit substrate and the second circuit substrate cannot be fixed until the first circuit substrate and the second circuit substrate are fixed by the common fixing member, and thus it is difficult to assemble the first circuit substrate and the second circuit substrate to the heat sink with high accuracy. In a case where the first circuit substrate and the second circuit substrate are temporarily fixed to the heat sink one by one before being fixed by the common fixing member in order to improve assembly accuracy, the manufacturing of the rotary electric machine becomes complicated, and a manufacturing cost increases.

The present disclosure has been made in order to solve the above-described problems, and an object of the present disclosure is to provide a rotary electric machine and a method for manufacturing the same which enable accurate assembly of a first circuit substrate and a second circuit substrate and can be manufactured easily and inexpensively.

### Means to Solve the Problem

A rotary electric machine according to the present disclosure includes a motor including a rotary shaft, and a control unit configured to control the motor, in which the control unit includes a substrate unit that includes a first circuit substrate, a second circuit substrate, and a holding member that is disposed between the first circuit substrate and the second circuit substrate and holds the first circuit substrate and the second circuit substrate, a heat sink that is disposed between the motor and the substrate unit and faces the first circuit substrate in an axial direction of the rotary shaft, and a fastening member that fixes the substrate unit to the heat sink, the holding member includes a base portion, a first locking portion that is connected to the base portion and locks the first circuit substrate from a second surface of the first circuit substrate on a side opposite to a first surface of the first circuit substrate facing the base portion, and a second locking portion that is connected to the base portion and locks the second circuit substrate from a fourth surface of the second circuit substrate on a side opposite to a third surface of the second circuit substrate facing the base portion, and the fastening member penetrates the substrate unit in the axial direction and is fastened to the heat sink.

A method for manufacturing a rotary electric machine according to the present disclosure includes a substrate unit assembling step of assembling a substrate unit by holding a first circuit substrate and a second circuit substrate by a holding member, and a substrate unit fixing step of fixing the substrate unit to a heat sink by causing a fastening member to penetrate the substrate unit in an axial direction of a rotary shaft of a motor and fastening the fastening member to the heat sink.

### Effects of the Invention

According to the present disclosure, it is possible to provide a rotary electric machine and a method for manufacturing the same which enable accurate assembly of a first circuit substrate and a second circuit substrate and can be manufactured easily and inexpensively.

### Brief Description of Drawings

[FIG. 1] An exploded perspective view of a rotary electric machine in a first embodiment.
[FIG. 2] A schematic cross-sectional view of the rotary electric machine in the first embodiment.
[FIG. 3] A perspective view of a first circuit substrate in the first embodiment.
[FIG. 4] A perspective view of a second circuit substrate in the first embodiment.
[FIG. 5] A perspective view of a holding member in the first embodiment.
[FIG. 6] A perspective view of a substrate unit in the first embodiment.
[FIG. 7] A perspective view of a heat sink in the first embodiment.
[FIG. 8] A perspective view of a connector in the first embodiment.
[FIG. 9A] A view for describing a method for manufacturing the rotary electric machine in the first embodiment.
[FIG. 9B] A view for describing the method for manufacturing the rotary electric machine in the first embodiment.
[FIG. 9C] A view for describing the method for manufacturing the rotary electric machine in the first embodiment.
[FIG. 9D] A view for describing the method for manufacturing the rotary electric machine in the first embodiment.
[FIG. 9E] A view for describing the method for manufacturing the rotary electric machine in the first embodiment.
[FIG. 9F] A view for describing the method for manufacturing the rotary electric machine in the first embodiment.
[FIG. 10] A perspective view of an intermediate structure of a rotary electric machine in a second embodiment as viewed from below.
[FIG. 11] A cross-sectional view taken along line A-A of FIG. 10.
[FIG. 12] A perspective view of a first circuit substrate in the second embodiment.
[FIG. 13] A perspective view of a second circuit substrate in the second embodiment.
[FIG. 14] A perspective view of a holding member in the second embodiment.
[FIG. 15] A perspective view of a holding member in a modification example of the second embodiment.

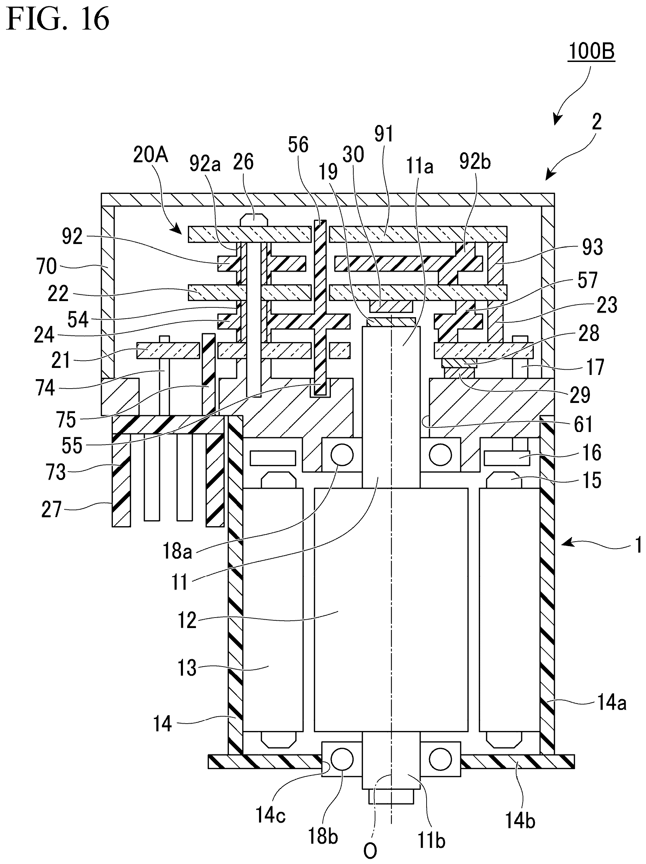

[FIG. 16] A schematic cross-sectional view of a rotary electric machine in a third embodiment.

### Description of Embodiments

Hereinafter, embodiments of the present disclosure will be described with reference to the drawings. The scope of the present disclosure is not limited to the following embodiments, and can be changed in any way within the scope of technical ideas of the present disclosure.

### First Embodiment.

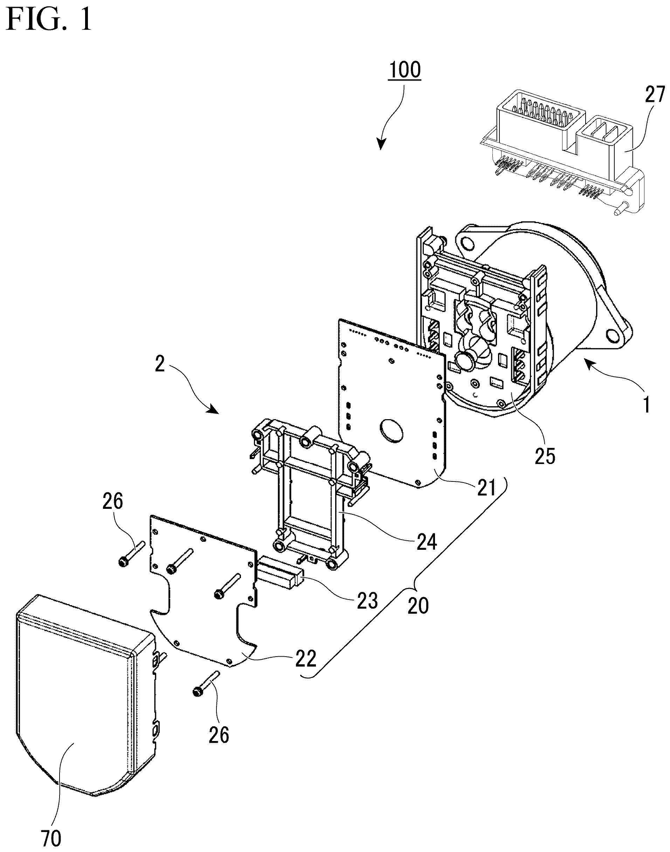

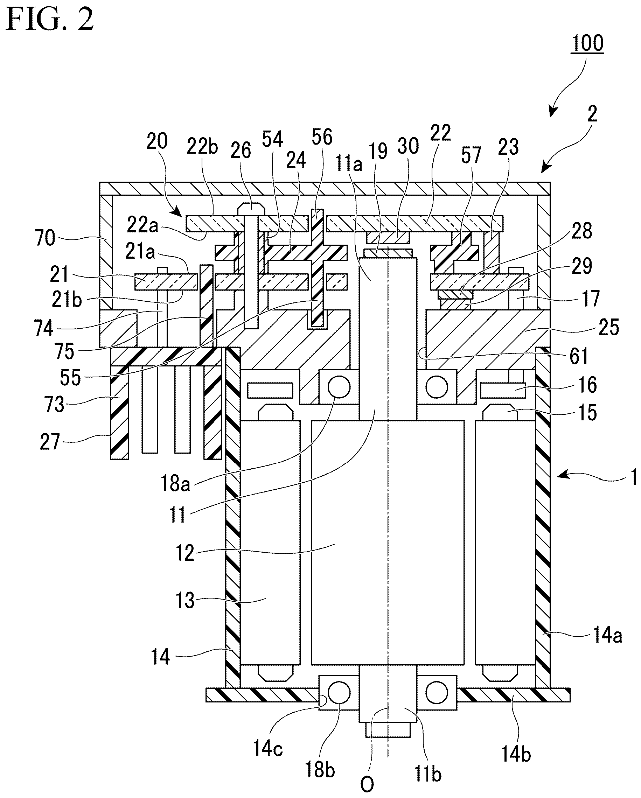

FIG. 1 is an exploded perspective view of a rotary electric machine 100 according to a first embodiment. FIG. 2 is a schematic cross-sectional view of the rotary electric machine 100. The rotary electric machine 100 includes a multi-phase winding type motor 1, and a control unit 2 that controls the motor 1. The control unit 2 includes a first circuit substrate 21, a second circuit substrate 22, an inter-substrate connector 23, a holding member 24, a heat sink 25, a fastening member 26, and a connector assembly 27.

As shown in FIG. 2, the motor 1 is mainly constituted by a rotary shaft 11, a rotor 12, a stator 13, a motor case 14, an armature winding 15, an annular wiring portion 16, a wiring terminal 17, and first and second bearings 18a and 18b.

In the following description, there are cases where a direction in which a central axis O of the rotary shaft 11 in the motor 1 extends is referred to as an axial direction. The motor 1 and the control unit 2 are arranged in the axial direction. There are cases where, in the axial direction, a side on which the control unit 2 is located is referred to as an upper side, and a side on which the motor 1 is located is referred to as a lower side. There are cases where viewing in the axial direction is referred to as a plan view. There are cases where, in a plan view, a direction intersecting the central axis O is referred to as a radial direction, and a direction that revolves around the central axis O is referred to as a circumferential direction.

The rotary shaft 11, the rotor 12, and the stator 13 are disposed coaxially.

The rotary shaft 11 includes an input end 11a located on the upper side and an output end 11b located on the lower side. A drive target (for example, a steering system of a vehicle) is connected to the output terminal 11b.

The rotor 12 is fixed to the rotary shaft 11. A plurality of pairs of permanent magnets (not shown) are disposed on an outer peripheral surface of the rotor 12. These permanent magnets constitute a field pole.

The stator 13 is provided to surround an outer periphery of the rotor 12. An air gap is formed between the outer peripheral surface of the rotor 12 and an inner peripheral surface of the stator 13. The air gap is formed over the entire circumference in the circumferential direction.

The motor case 14 accommodates the rotary shaft 11, the rotor 12, and the stator 13. The motor case 14 includes a cylindrical portion 14a and a bottom portion 14b. The cylindrical portion 14a covers the stator 13 from an outer peripheral side. The stator 13 is fixed to an inner surface of the cylindrical portion 14a by shrink fitting or press fitting. The bottom portion 14b covers a lower end of the cylindrical portion 14a. An output-side shaft through-hole 14c through which the rotary shaft 11 is inserted is formed at a center of the bottom portion 14b in a plan view. An upper end of the cylindrical portion 14a is covered with the heat sink 25 of the control unit 2.

The armature winding 15 is wound around the stator 13. The armature winding 15 includes a U-phase winding, a V-phase winding, and a W-phase winding.

The annular wiring portion 16 is disposed above the stator 13. The annular wiring portion 16 is disposed close to the armature winding 15. The annular wiring portion 16 is connected to an end portion of the armature winding 15 by TIG welding or the like.

The wiring terminal 17 extends upward from the annular wiring portion 16, penetrating the heat sink 25. The wiring terminal 17 is electrically connected to the end portion of the armature winding 15 via the annular wiring portion 16. More specifically, the wiring terminal 17 is constituted by three conductors, and the three conductors are electrically connected to an end portion of the U-phase winding, an end portion of the V-phase winding, and an end portion of the W-phase winding of the armature winding 15, respectively. An upper end portion of the wiring terminal 17 is connected to the first circuit substrate 21 of the control unit 2.

The input end 11a of the rotary shaft 11 is inserted through a first shaft through-hole 61 formed in the heat sink 25. The output end 11b of the rotary shaft 11 is inserted through the output-side shaft through-hole 14c formed in the bottom portion 14b. The first bearing 18a is provided in the first shaft through-hole 61. The second bearing 18b is provided in the output-side shaft through-hole 14c. The first bearing 18a and the second bearing 18b support the rotary shaft 11 to be rotatable.

A sensor magnet 19 is attached to the input end 11a of the rotary shaft 11. The sensor magnet 19 is fixed by press fitting to an end surface of the input end 11a facing the axial direction. The sensor magnet 19 includes one pair or a plurality of pairs of permanent magnets. The sensor magnet 19 rotates together with the rotary shaft 11. A magnetic field generated by the sensor magnet 19 changes with the rotation of the rotary shaft 11.

The control unit 2 controls the motor 1. In the axial direction, the second circuit substrate 22, the holding member 24, the first circuit substrate 21, and the heat sink 25 are disposed in this order from above. A substrate unit 20 is constituted by the first circuit substrate 21, the second circuit substrate 22, the inter-substrate connector 23, and the holding member 24.

The control unit 2 is covered with a cover 70 from above. The cover 70 is attached to the heat sink 25. The substrate unit 20 (the first circuit substrate 21, the second circuit substrate 22, the inter-substrate connector 23, and the holding member 24) is accommodated in a space surrounded by the cover 70 and the heat sink 25.

The first circuit substrate 21 is disposed between the holding member 24 and the heat sink 25 in the axial direction. The first circuit substrate 21 has a first surface 21a and a second surface 21b. The first surface 21a is an upper surface of the first circuit substrate 21, and the second surface 21b is a lower surface of the first circuit substrate 21.

An inverter circuit that drives the motor 1 is mounted on the first circuit substrate 21. The inverter circuit is constituted by electronic components such as a switching element, a shunt resistor, and a smoothing capacitor. Among these electronic components, an electronic component 28, which is a heat generating element that generates heat with the driving of the motor 1, is preferably disposed on the second surface 21b of the first circuit substrate 21. The electronic component 28 is in contact with an upper surface of the heat sink 25 via a thermal grease 29. The heat generated by the electronic component 28 is dissipated to the heat sink 25 via the thermal grease 29. The electronic component 28 may be disposed on the first surface 21a of the first circuit substrate 21.

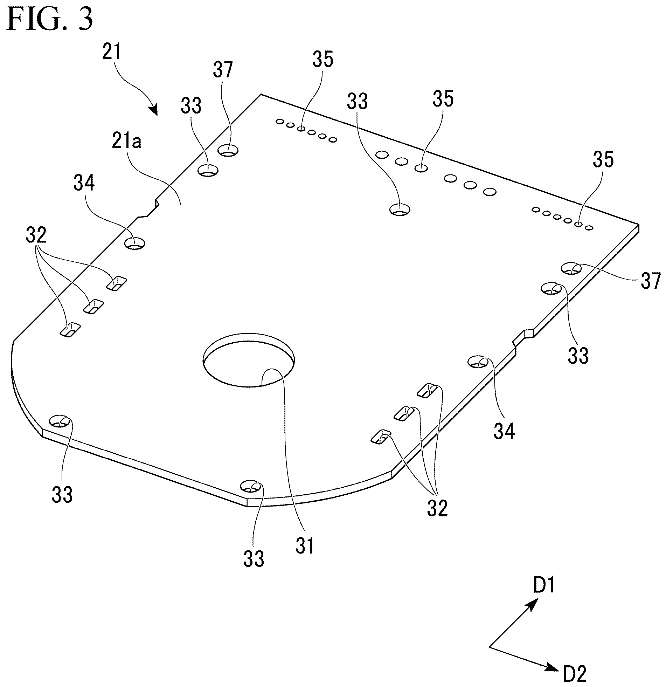

FIG. 3 is a perspective view of the first circuit substrate 21 from above. In the following description, as shown in FIG. 3, a direction in a plane along the first surface 21a of the first circuit substrate 21 is referred to as a first direction D1, and a direction orthogonal to the first direction D1 in the plane is referred to as a second direction D2. The first direction D1 and the second direction D2 are orthogonal to the axial direction.

The first circuit substrate 21 is provided with a second shaft through-hole 31, a motor terminal connection hole 32 (motor connection portion), a first fastening through-hole 33, a first positioning through-hole 34, a connector terminal connection hole 35 (first connector connection portion), and a connector positioning through-hole 37.

The second shaft through-hole 31 penetrates the first circuit substrate 21 in the axial direction. The second shaft through-hole 31 is disposed at a position overlapping the output-side shaft through-hole 14c in a plan view. The input end 11a of the rotary shaft 11 is inserted through the second shaft through-hole 31.

The motor terminal connection hole 32 penetrates the first circuit substrate 21 in the axial direction. The motor terminal connection hole 32 is provided at an end portion of the first circuit substrate 21 in the second direction D2. The three motor terminal connection holes 32 are disposed in a row in the first direction D1. The three motor terminal connection holes 32 are connected to the three conductors of the wiring terminal 17, respectively.

The first fastening through-hole 33 penetrates the first circuit substrate 21 in the axial direction. The first fastening through-hole 33 is provided at an outer edge portion of the first circuit substrate 21. In the present embodiment, a plurality of the first fastening through-holes 33 are provided at both end portions in the first direction D1 and both end portions in the second direction D2 of the first circuit substrate 21. The fastening member 26 is inserted through the first fastening through-hole 33.

The first positioning through-hole 34 penetrates the first circuit substrate 21 in the axial direction. The first positioning through-hole 34 is provided at the outer edge portion of the first circuit substrate 21. In the present embodiment, a pair of the first positioning through-holes 34 are provided at both end portions of the first circuit substrate 21 in the second direction D2. A first positioning protrusion 55 of the holding member 24, which will be described later, is inserted through the first positioning through-hole 34.

The connector terminal connection hole 35 penetrates the first circuit substrate 21 in the axial direction. The connector terminal connection hole 35 is provided at one end portion of the first circuit substrate 21 in the first direction D1. In the present embodiment, a plurality of the connector terminal connection holes 35 are disposed in a row in the second direction D2. A press-fit terminal 74 of the connector assembly 27, which will be described later, is connected to the connector terminal connection hole 35.

The connector positioning through-hole 37 penetrates the first circuit substrate 21 in the axial direction. The connector positioning through-hole 37 is provided at the one end portion of the first circuit substrate 21 in the first direction D1. In the present embodiment, a pair of the connector positioning through-holes 37 are provided to be disposed on both sides of the plurality of connector terminal connection holes 35 in the second direction D2 when viewed in the first direction D1. A connector positioning protrusion 75 of the connector assembly 27, which will be described later, is inserted through the connector positioning through-hole 37.

Returning to FIG. 2, the second circuit substrate 22 is disposed above the first circuit substrate 21. The second circuit substrate 22 has a third surface 22a and a fourth surface 22b. The third surface 22a is a lower surface of the second circuit substrate 22, and the fourth surface 22b is an upper surface of the second circuit substrate 22.

A control circuit that controls the driving of the motor 1 is mounted on the second circuit substrate 22. The control circuit is constituted by a microcontroller that performs a drive control of the motor 1, a drive circuit used for controlling the switching element, and the like.

A rotation sensor 30 is mounted on the third surface 22a of the second circuit substrate 22. The rotation sensor 30 is a magnetic sensor such as a magnetoresistive sensor (MR sensor) or a Hall sensor. The rotation sensor 30 is disposed coaxially with the sensor magnet 19 attached to the rotary shaft 11. The sensor magnet 19 and the rotation sensor 30 face each other with a gap therebetween. The rotation sensor 30 detects a change in the magnetic field from the permanent magnets of the sensor magnet 19 that rotates together with the rotary shaft 11, and converts the change into an electric signal. A rotation angle of the rotary shaft 11 is detected by the sensor magnet 19 and the rotation sensor 30. A resolver, an optical sensor, or the like may be used as the rotation sensor 30.

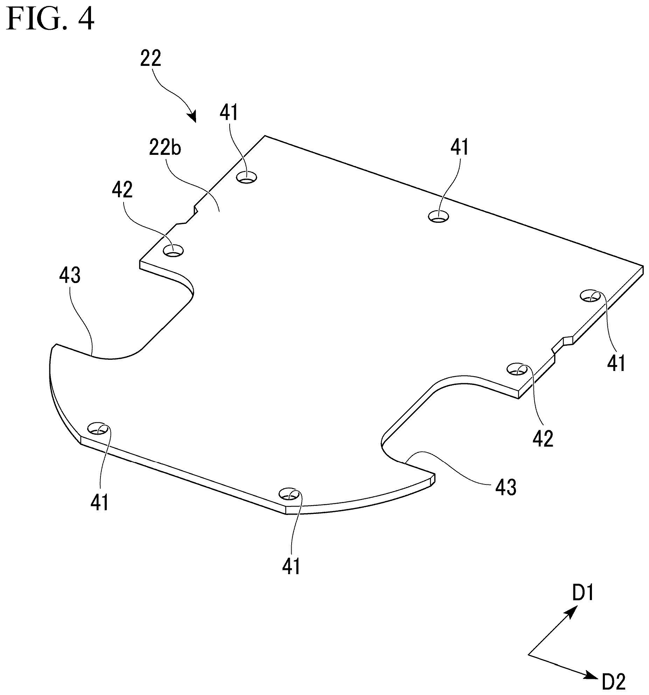

FIG. 4 is a perspective view of the second circuit substrate 22 from above. As shown in FIG. 4, the second circuit substrate 22 is provided with a second fastening through-hole 41, a second positioning through-hole 42, and a cutout portion 43.

The second fastening through-hole 41 penetrates the second circuit substrate 22 in the axial direction. The second fastening through-hole 41 is provided at an outer edge portion of the second circuit substrate 22. In the present embodiment, a plurality of the second fastening through-holes 41 are disposed at positions overlapping the plurality of first fastening through-holes 33 in a plan view. The fastening member 26 is inserted through the second fastening through-hole 41.

The second positioning through-hole 42 penetrates the second circuit substrate 22 in the axial direction. The second positioning through-hole 42 is provided at the outer edge portion of the second circuit substrate 22. In the present embodiment, a pair of the second positioning through-holes 42 are disposed at positions overlapping the pair of first positioning through-holes 34 in a plan view. The first positioning through-holes 34 and the second positioning through-holes 42 may be disposed at different positions in a plan view. A second positioning protrusion 56 of the holding member 24, which will be described later, is inserted through the second positioning through-hole 42.

The cutout portion 43 is provided to be recessed inward from an end edge of the second circuit substrate 22 in the second direction D2. In the present embodiment, a pair of the cutout portions 43 are provided at both end portions of the second circuit substrate 22 in the second direction D2. The cutout portion 43 is formed at a position overlapping the motor terminal connection hole 32 in a plan view. When the substrate unit 20 is viewed in the axial direction from the side of the second circuit substrate 22, the cutout portion 43 exposes the motor terminal connection hole 32.

A length of the second circuit substrate 22 in the first direction D1 is shorter than a length of the first circuit substrate 21 in the first direction D1. When the substrate unit 20 is viewed in the axial direction from the side of the second circuit substrate 22, the one end portion (the connector terminal connection hole 35) of the first circuit substrate 21 in the first direction D1 is exposed from the second circuit substrate 22.

Returning to FIG. 2, the inter-substrate connector 23 is disposed between the first circuit substrate 21 and the second circuit substrate 22 in the axial direction. The inter-substrate connector 23 electrically connects the inverter circuit of the first circuit substrate 21 and the control circuit of the second circuit substrate 22. The inter-substrate connector 23 is constituted by a male connector mounted on the first circuit substrate 21 and a female connector mounted on the second circuit substrate 22. The male connector and the female connector are fitted to each other, and thus the first circuit substrate 21 and the second circuit substrate 22 are electrically connected to each other via the inter-substrate connector 23. A bent substrate may be used as the inter-substrate connector 23, or a connector in which a tip of a terminal has a press-fit shape may be used.

The holding member 24 is disposed between the first circuit substrate 21 and the second circuit substrate 22 in the axial direction. The substrate unit 20 is assembled by holding the first circuit substrate 21 and the second circuit substrate 22 by the holding member 24 in a state where the first circuit substrate 21 and the second circuit substrate 22 are electrically connected to each other via the inter-substrate connector 23.

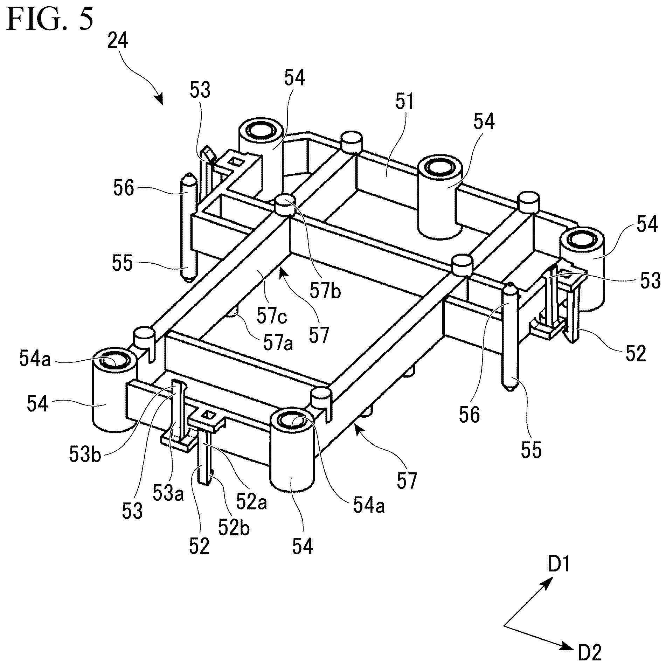

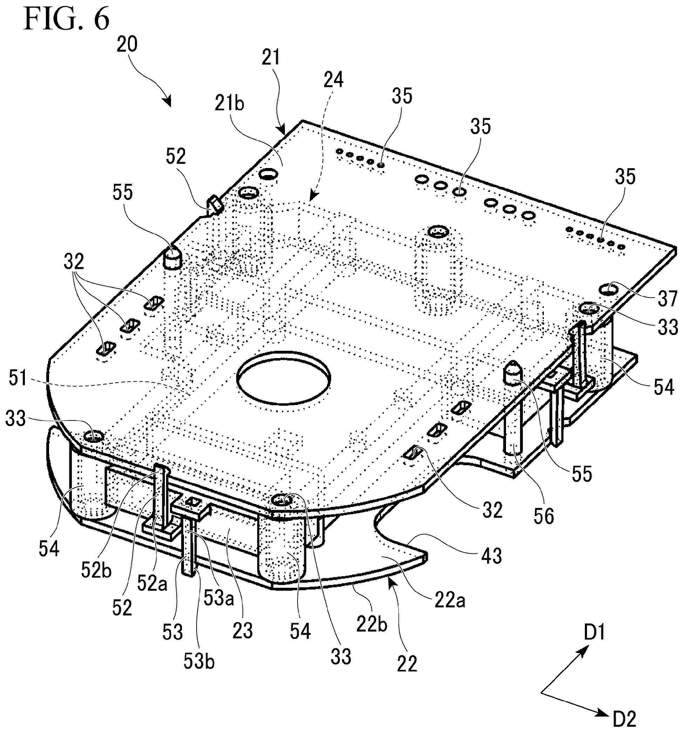

FIG. 5 is a perspective view of the holding member 24 from above. FIG. 6 is a perspective view of the substrate unit 20 from below.

As shown in FIG. 5, the holding member 24 includes a base portion 51, a first locking portion 52, a second locking portion 53, a spacer 54, the first positioning protrusion 55, the second positioning protrusion 56, and a load transmission portion 57.

The base portion 51 has a frame shape having an inner space. The members 52 to 57 of the holding member 24 are connected to the base portion 51. The electronic components mounted on the first circuit substrate 21 and the second circuit substrate 22, including the rotation sensor 30, are accommodated in the inner space of the base portion 51. Accordingly, the inner space of the base portion 51 can be used for accommodating the electronic components, thereby achieving a reduction in size of the substrate unit 20.

The first locking portion 52 locks the first circuit substrate 21 from the second surface 21b of the first circuit substrate 21 (that is, a surface of the first circuit substrate 21 opposite to the first surface 21a facing the base portion 51). As shown in FIG. 6, a plurality of the first locking portions 52 are provided to surround the first circuit substrate 21. The first locking portion 52 has a first protruding portion 52a extending downward (that is, toward the first circuit substrate 21) from the base portion 51, and a first locking claw 52b located at a tip of the first protruding portion 52a. The first locking claw 52b has a first locking surface facing upward. The first locking surface of the first locking claw 52b abuts on the second surface 21b of the first circuit substrate 21, whereby the first circuit substrate 21 is fixed to the holding member 24 in the axial direction.

The second locking portion 53 locks the second circuit substrate 22 from the fourth surface 22b of the second circuit substrate 22 (that is, a surface of the second circuit substrate 22 opposite to the third surface 22a facing the base portion 51). As shown in FIG. 6, a plurality of the second locking portions 53 are provided to surround the second circuit substrate 22. The second locking portion 53 has a second protruding portion 53a extending upward (that is, toward the second circuit substrate 22) from the base portion 51, and a second locking claw 53b located at a tip of the second protruding portion 53a. The second locking claw 53b has a second locking surface facing downward. The second locking surface of the second locking claw 53b abuts on the fourth surface 22b of the second circuit substrate 22, whereby the second circuit substrate 22 is fixed to the holding member 24 in the axial direction.

The spacer 54 has a cylindrical shape extending in the axial direction. In the present embodiment, a plurality of the spacers 54 are disposed at positions overlapping the plurality of first fastening through-holes 33 in a plan view. One end of the spacer 54 in the axial direction abuts on the first circuit substrate 21, and the other end of the spacer 54 in the axial direction abuts on the second circuit substrate 22. The spacer 54 secures an interval between the first circuit substrate 21 and the second circuit substrate 22. The spacer 54 has a third fastening through-hole 54a that penetrates the spacer 54 in the axial direction. The fastening member 26 is inserted through the third fastening through-hole 54a.

When the substrate unit 20 is assembled, the second fastening through-hole 41 of the second circuit substrate 22, the third fastening through-hole 54a of the holding member 24, and the first fastening through-hole 33 of the first circuit substrate 21 are disposed coaxially in this order from above. The second fastening through-hole 41, the third fastening through-hole 54a, and the first fastening through-hole 33 communicate with each other. Hereinafter, the second fastening through-hole 41, the third fastening through-hole 54a, and the first fastening through-hole 33 are collectively referred to as a fastening through-hole of the substrate unit 20.

The first positioning protrusion 55 has a columnar shape extending in the axial direction. In the present embodiment, a pair of the first positioning protrusions 55 are provided to correspond to the pair of first positioning through-holes 34. The first positioning protrusion 55 extends downward from the base portion 51. The first positioning protrusion 55 is inserted through the first positioning through-hole 34. The first circuit substrate 21 is positioned with respect to the holding member 24 by the first positioning protrusion 55. A height of the first positioning protrusion 55 is greater than a height of the first locking portion 52. That is, a tip of the first positioning protrusion 55 is located below a tip of the first locking portion 52.

In addition, the first positioning protrusion 55 is fitted into a fitting hole 64 of the heat sink 25, which will be described later. As a result, the substrate unit 20 is positioned with respect to the heat sink 25.

The second positioning protrusion 56 has a columnar shape extending in the axial direction. In the present embodiment, a pair of the second positioning protrusions 56 are provided to correspond to the pair of second positioning through-holes 42. The second positioning protrusion 56 extends upward from the base portion 51. The second positioning protrusion 56 is inserted through the second positioning through-hole 42. The second circuit substrate 22 is positioned with respect to the holding member 24 by the second positioning protrusion 56. A height of the second positioning protrusion 56 is greater than a height of the second locking portion 53. That is, a tip of the second positioning protrusion 56 is positioned above a tip of the second locking portion 53.

In the present embodiment, the first positioning protrusion 55 and the second positioning protrusion 56 are disposed at positions that overlap each other in a plan view. However, the first positioning protrusions 55 and the second positioning protrusions 56 may be disposed at different positions in a plan view.

The load transmission portion 57 is disposed at a position overlapping the thermal grease 29 in a plan view. The load transmission portion 57 includes a first abutting portion 57a that abuts on the first circuit substrate 21, a second abutting portion 57b that abuts on the second circuit substrate 22, and a connection portion 57c that connects the first abutting portion 57a and the second abutting portion 57b. The first abutting portion 57a is a protrusion provided on a lower surface of the base portion 51. The second abutting portion 57b is a protrusion provided on an upper surface of the base portion 51. The connection portion 57c is a part of the base portion 51. A load applied to the second circuit substrate 22 during manufacturing of the rotary electric machine 100 is transmitted to the first circuit substrate 21 via the load transmission portion 57.

Returning to FIG. 2, the heat sink 25 is disposed between the stator 13 and the substrate unit 20 (first circuit substrate 21) in the axial direction. The heat sink 25 is fitted into the cylindrical portion 14a of the motor case 14. The heat sink 25 covers the stator 13 from above. The heat sink 25 separates a space in which the rotor 12 and the stator 13 of the motor 1 are accommodated from a space in which the substrate unit 20 of the control unit 2 is accommodated.

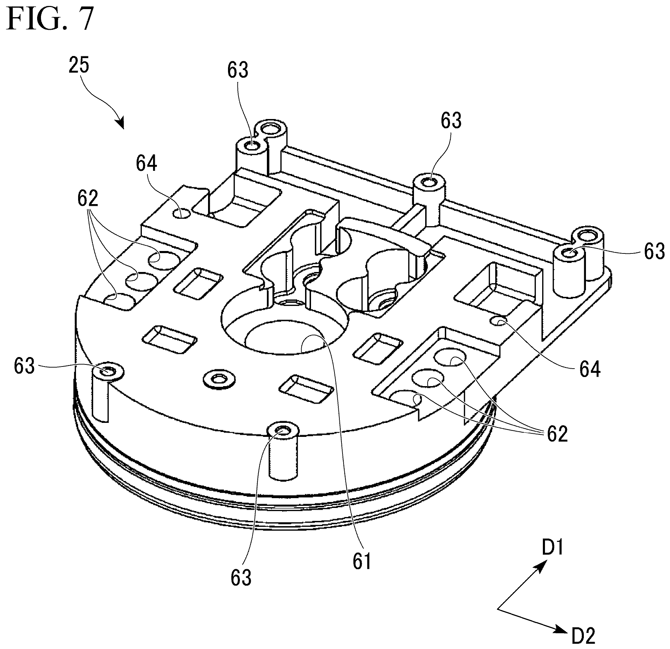

FIG. 7 is a perspective view of the heat sink 25 from above. As shown in FIG. 7, the heat sink 25 is provided with the first shaft through-hole 61, the motor terminal through-hole 62, a fastening hole 63, and a fitting hole 64.

The first shaft through-hole 61 penetrates the heat sink 25 in the axial direction. The first shaft through-hole 61 is disposed at a position overlapping the output-side shaft through-hole 14c in a plan view. The input end 11a of the rotary shaft 11 is inserted through the first shaft through-hole 61.

The motor terminal through-hole 62 penetrates the heat sink 25 in the axial direction. The motor terminal through-hole 62 is provided at an end portion of the heat sink 25 in the second direction D2. The three motor terminal through-holes 62 are disposed in a row in the first direction D1. The three motor terminal through-holes 62 are disposed at positions overlapping the three motor terminal connection holes 32 in a plan view. The three conductors of the wiring terminal 17 are inserted through the three motor terminal through-holes 62, respectively. In a plan view, a size of the motor terminal through-hole 62 is larger than a size of the wiring terminal 17. Therefore, when the wiring terminal 17 is inserted through the motor terminal through-hole 62, the wiring terminal 17 and the motor terminal through-hole 62 are prevented from coming into contact with each other.

The fastening hole 63 is provided at an outer edge portion of the heat sink 25. The fastening hole 63 is recessed downward from the upper surface of the heat sink 25. In the present embodiment, a plurality of the fastening holes 63 are disposed at positions overlapping the plurality of first fastening through-holes 33 in a plan view. The fastening member 26 is fastened to the fastening hole 63.

The fitting hole 64 is provided at the outer edge portion of the heat sink 25. The fitting hole 64 is recessed downward from the upper surface of the heat sink 25. In the present embodiment, a pair of the fitting holes 64 are disposed at positions overlapping the pair of first positioning through-holes 34 in a plan view. The first positioning protrusion 55 is fitted into the fitting hole 64.

The fastening member 26 is used to fix the substrate unit 20 to the heat sink 25. In the present embodiment, a plurality of the fastening members 26 are provided corresponding to a plurality of the fastening through-holes of the substrate unit 20. The fastening member 26 is inserted through the fastening through-hole of the substrate unit 20 from the side of the second circuit substrate 22 and is fastened to the fastening hole 63 of the heat sink 25. That is, the fastening member 26 penetrates the substrate unit 20 in the axial direction and is fastened to the heat sink 25.

The fastening member 26 is, for example, a screw. The fastening member 26 has a head portion that abuts on the second circuit substrate 22 and a shaft portion extending from the head portion in the axial direction. The shaft portion of the fastening member 26 is inserted through the fastening through-hole of the substrate unit 20 and is fastened to the fastening hole 63 of the heat sink 25. In a plan view, an outer shape of the head portion of the fastening member 26 is substantially the same as an outer shape of the spacer 54.

In addition, it is preferable that a material of the fastening member 26 is the same as a material of the spacer 54. In this case, it is possible to suppress a change in fastening force of the fastening member 26 with respect to the first circuit substrate 21 and the second circuit substrate 22 due to a temperature change.

The connector assembly 27 electrically connects the rotary electric machine 100 to an external power supply, a sensor, and the like. The connector assembly 27 is provided on a lower surface of the heat sink 25. The connector assembly 27 faces the first circuit substrate 21 via the heat sink 25. The connector assembly 27 is connected to the first circuit substrate 21. **In** the present embodiment, the connector assembly 27 is provided below the first circuit substrate 21, but the connector assembly 27 may be provided above the first circuit substrate 21.

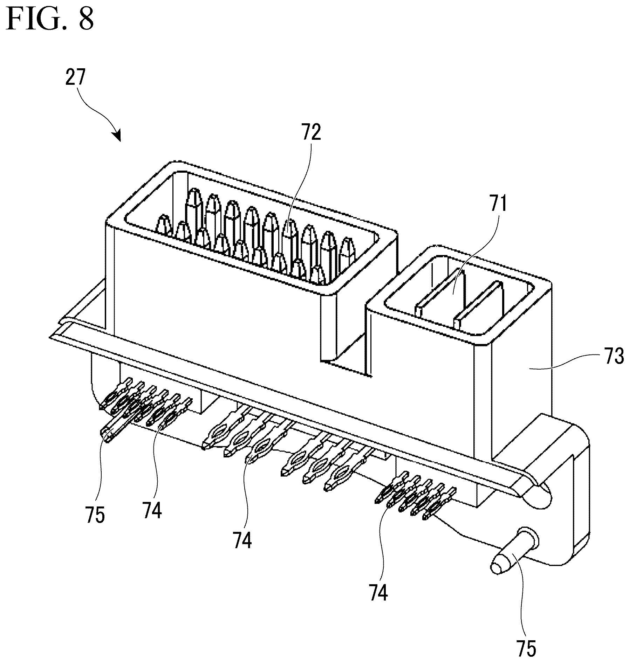

FIG. 8 is a perspective view of the connector assembly 27. As shown in FIG. 8, the connector assembly 27 includes a power supply terminal 71, a signal terminal 72, a connector holding portion 73, and the connector positioning protrusion 75.

The power supply terminal 71 is connected to the external power supply. The signal terminal 72 is connected to an external sensor or the like. Power from the external power supply is supplied to the first circuit substrate 21 via the power supply terminal 71. Various signals from the external sensor or the like are supplied to the first circuit substrate 21 via the signal terminal 72. The power supply terminal 71 and the signal terminal 72 are held by the connector holding portion 73.

End portions of the power supply terminal 71 and the signal terminal 72 on the side of the first circuit substrate 21 are the press-fit terminals 74 (first press-fit terminals). The press-fit terminal 74 extends from the connector holding portion 73 toward the first circuit substrate 21. A plurality of the press-fit terminals 74 are press-fitted into the plurality of connector terminal connection holes 35, respectively. The press-fit terminal 74 comes into contact with a conductive layer formed on an inner surface of the connector terminal connection hole 35, whereby the press-fit terminal 74 and the connector terminal connection hole 35 are electrically connected to each other.

The connector positioning protrusion 75 is formed in a columnar shape. **In** the present embodiment, a pair of the connector positioning protrusions 75 are provided to correspond to the pair of connector positioning through-holes 37. The connector positioning protrusion 75 extends from the connector holding portion 73 toward the first circuit substrate 21. The connector positioning protrusion 75 is inserted through the connector positioning through-hole 37. The connector assembly 27 is positioned with respect to the first circuit substrate 21 by the connector positioning protrusion 75. A height of the connector positioning protrusion 75 is greater than a height of the press-fit terminal 74. That is, a tip of the connector positioning protrusion 75 is located on the side of the first circuit substrate 21 with respect to a tip of the press-fit terminal 74.

Next, a method for manufacturing the rotary electric machine 100 will be described. The method for manufacturing the rotary electric machine 100 according to the present embodiment includes a substrate unit assembling step, a substrate unit fixing step, a connector attaching step, and a cover attaching step.

In the substrate unit assembling step, the substrate unit 20 is assembled by holding the first circuit substrate 21 and the second circuit substrate 22 by the holding member 24.

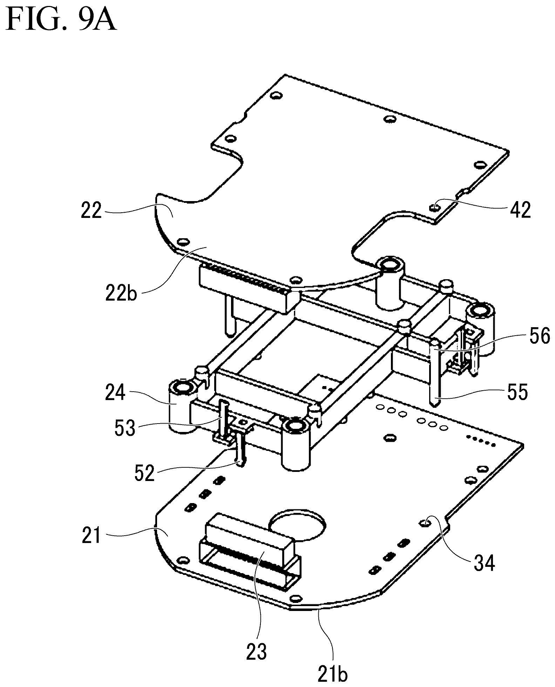

Specifically, as shown in FIG. 9A, the first positioning protrusions 55 are inserted through the first positioning through-holes 34, and the first circuit substrate 21 is locked by the first locking portions 52 from the second surface 21b of the first circuit substrate 21. Accordingly, the first circuit substrate 21 is fixed to the holding member 24. The height of the first positioning protrusion 55 is greater than the height of the first locking portion 52. Therefore, the first circuit substrate 21 can be locked by the first locking portions 52 in a state where the first circuit substrate 21 is positioned with respect to the holding member 24 by the first positioning protrusions 55.

The second positioning protrusions 56 are inserted through the second positioning through-holes 42, and the second circuit substrate 22 is locked by the second locking portions 53 from the fourth surface 22b of the second circuit substrate 22. Accordingly, the second circuit substrate 22 is fixed to the holding member 24. The height of the second positioning protrusion 56 is greater than the height of the second locking portion 53. Therefore, the second circuit substrate 22 can be locked by the second locking portions 53 in a state where the second circuit substrate 22 is positioned with respect to the holding member 24 by the second positioning protrusions 56.

In addition, the male connector of the inter-substrate connector 23 mounted on the first circuit substrate 21 and the female connector of the inter-substrate connector 23 mounted on the second circuit substrate 22 are fitted to each other such that the first circuit substrate 21 and the second circuit substrate 22 are electrically connected to each other through the inter-substrate connector 23.

In the substrate unit fixing step, the substrate unit 20 is fixed to the heat sink 25 by the fastening members 26.

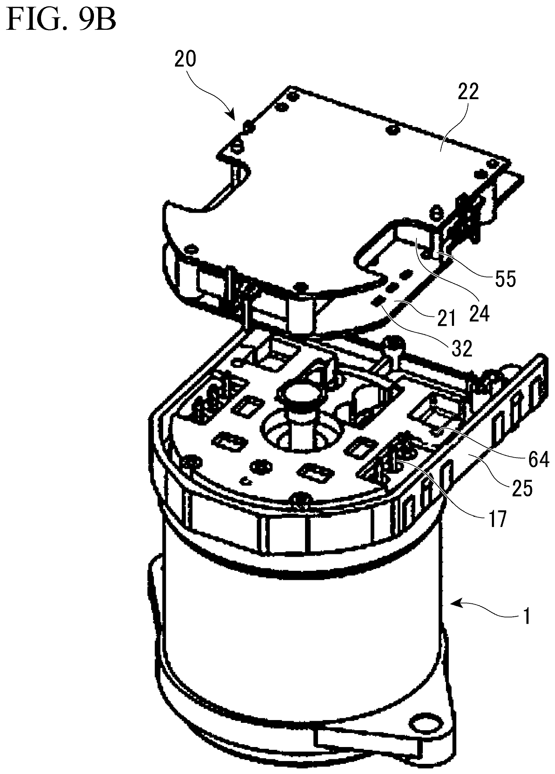

Specifically, as shown in FIG. 9B, the substrate unit 20 is disposed such that the first circuit substrate 21 and the heat sink 25 face each other. The heat sink 25 is attached to the motor 1 in advance.

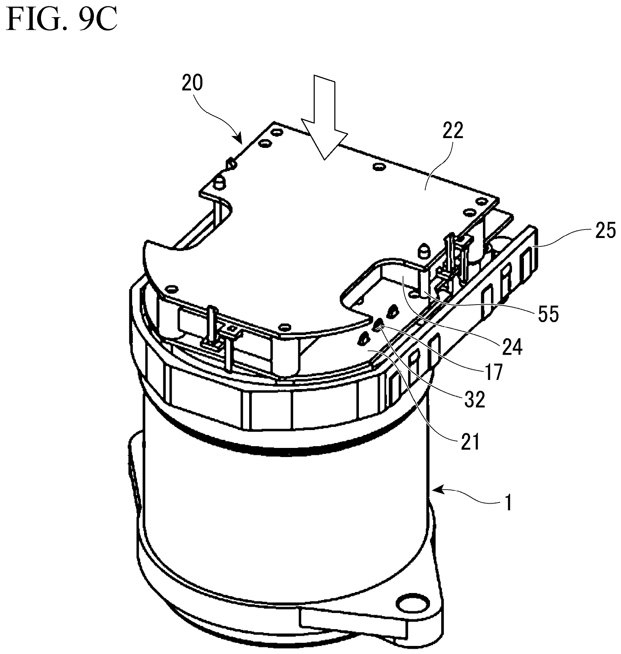

As shown in FIG. 9C, the substrate unit 20 is placed on the upper surface of the heat sink 25. At this time, the first positioning protrusions 55 are fitted into the fitting holes 64 (see FIG. 9B) of the heat sink 25, whereby the substrate unit 20 is positioned with respect to the heat sink 25. The wiring terminal 17 is inserted through the motor terminal connection holes 32. In addition, a load is applied to the second circuit substrate 22 toward the heat sink 25 (arrow direction in FIG. 9C) by a jig or the like, and the second circuit substrate 22 is pressed against the heat sink 25. The load applied to the second circuit substrate 22 is transmitted to the first circuit substrate 21 via the load transmission portion 57. As a result, the first circuit substrate 21 is also pressed against the heat sink 25, and the thermal grease 29 applied between the heat sink 25 and the electronic component 28 mounted on the first circuit substrate 21 is spread.

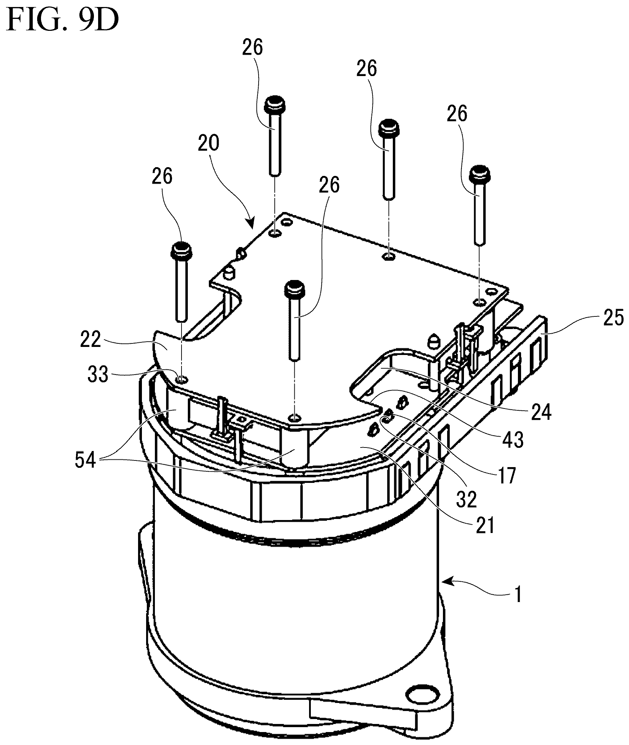

Thereafter, as shown in FIG. 9D, the fastening members 26 are inserted through the fastening through-hole of the substrate unit 20 from the side of the second circuit substrate 22 and are fastened to the fastening holes 63 of the heat sink 25. The wiring terminal 17 and the motor terminal connection hole 32 are electrically connected to each other by soldering or the like. In this case, since the cutout portion 43 is provided in the second circuit substrate 22, it is possible to prevent a connection tool for connecting the wiring terminal 17 to the motor terminal connection hole 32 from interfering with the second circuit substrate 22.

In the connector attaching step, the connector assembly 27 is connected to the first circuit substrate 21.

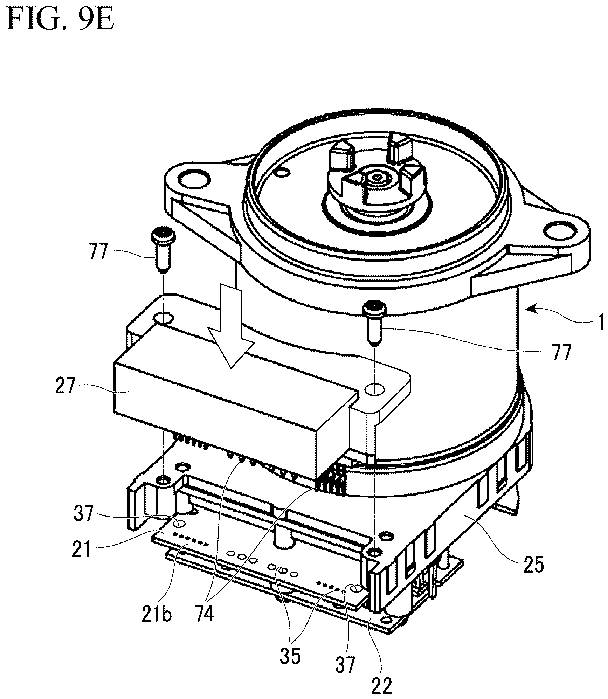

Specifically, as shown in FIG. 9E, an intermediate structure of the rotary electric machine 100 after the substrate unit fixing step is turned upside down. The connector assembly 27 is caused to face the second surface 21b of the first circuit substrate 21. The connector positioning protrusions 75 (see FIG. 7) are inserted through the connector positioning through-holes 37 of the first circuit substrate 21. A load is applied to the connector assembly 27 toward the first circuit substrate 21 (arrow direction in FIG. 9E), and the press-fit terminals 74 are press-fitted into the connector terminal connection holes 35 of the first circuit substrate 21. The height of the connector positioning protrusion 75 is greater than the height of the press-fit terminal 74. Therefore, the press-fit terminals 74 can be press-fitted into the connector terminal connection holes 35 in a state where the connector assembly 27 is positioned with respect to the first circuit substrate 21 by the connector positioning protrusions 75.

Here, when the press-fit terminal 74 is press-fitted into the connector terminal connection hole 35, a pressing force is applied to the first circuit substrate 21. By installing a receiving jig (not shown) on the first surface 21a of the first circuit substrate 21, the pressing force applied to the first circuit substrate 21 can be received by the receiving jig. Therefore, distortion of the first circuit substrate 21 can be suppressed, and poor connection of the press-fit terminal 74 due to an insufficient insertion amount of the press-fit terminal 74 into the connector terminal connection hole 35 can be prevented.

Thereafter, the connector assembly 27 is screwed and fixed to the heat sink 25 by second fastening members 77.

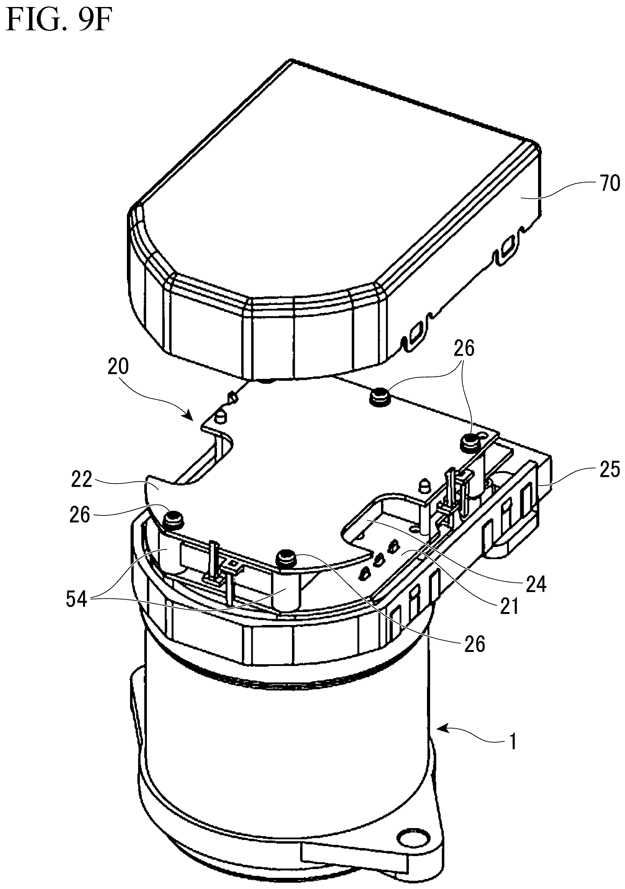

As shown in FIG. 9F, in the cover attaching step, the intermediate structure of the rotary electric machine 100 after the connector attaching step is turned upside down again. The cover 70 is assembled to the heat sink 25 from above.

As a result, the rotary electric machine 100 is completed.

As described above, the rotary electric machine 100 according to the present embodiment includes the motor 1 including the rotary shaft 11 and the control unit 2 that controls the motor 1. The control unit 2 includes the substrate unit 20 that includes the first circuit substrate 21, the second circuit substrate 22, and the holding member 24 that is disposed between the first circuit substrate 21 and the second circuit substrate 22 and holds the first circuit substrate 21 and the second circuit substrate 22, the heat sink 25 that is disposed between the motor 1 and the substrate unit 20 and faces the first circuit substrate 21 in the axial direction, and the fastening member 26 that fixes the substrate unit 20 to the heat sink 25. The holding member 24 includes the base portion 51, the first locking portion 52 that is connected to the base portion 51 and locks the first circuit substrate 21 from the second surface 21b of the first circuit substrate 21, and the second locking portion 53 that is connected to the base portion 51 and locks the second circuit substrate 22 from the fourth surface 22b of the second circuit substrate 22. The fastening member 26 penetrates the substrate unit 20 in the axial direction and is fastened to the heat sink 25.

In addition, the method for manufacturing the rotary electric machine 100 according to the present embodiment includes the substrate unit assembling step of assembling the substrate unit 20 by holding the first circuit substrate 21 and the second circuit substrate 22 by the holding member 24, and the substrate unit fixing step of fixing the substrate unit 20 to the heat sink 25 by causing the fastening member 26 to penetrate the substrate unit 20 in the axial direction and fastening the fastening member 26 to the heat sink 25.

With the rotary electric machine 100 or the method for manufacturing the rotary electric machine 100, the substrate unit 20 is assembled by holding the first circuit substrate 21 and the second circuit substrate 22 by the holding member 24. Thereafter, the substrate unit 20 is fixed to the heat sink 25 by the fastening member 26, so that the first circuit substrate 21 and the second circuit substrate 22 can be assembled to the heat sink 25 at once and with high accuracy. Since it is not necessary to assemble the circuit substrates 21 and 22 one by one, the manufacturing of the rotary electric machine 100 is facilitated. In addition, since a manufacturing line of the rotary electric machine 100 can be shared with a manufacturing line of a rotary electric machine in which a control unit is constituted by one circuit substrate, a manufacturing cost can be reduced.

In addition, for example, in a case where the rotation sensor 30 that detects the rotation angle of the rotary shaft 11 is mounted on the first circuit substrate 21 or the second circuit substrate 22, when positions of the first circuit substrate 21 and the second circuit substrate 22 deviate with respect to the rotary shaft 11, there is a possibility that detection accuracy of the rotation sensor 30 decreases. Since the first circuit substrate 21 and the second circuit substrate 22 can be assembled to the heat sink 25 with high accuracy, it is possible to prevent the deviation of the positions of the first circuit substrate 21 and the second circuit substrate 22 with respect to the rotary shaft 11, and it is possible to prevent a decrease in the detection accuracy of the rotation sensor 30.

In addition, the holding member 24 further includes the spacer 54 that is connected to the base portion 51, extends in the axial direction, and abuts on the first circuit substrate 21 and the second circuit substrate 22. The fastening member 26 is inserted through the spacer 54.

According to this configuration, the spacer 54 can secure the interval between the first circuit substrate 21 and the second circuit substrate 22. Therefore, the manufacturing of the rotary electric machine 100 is further facilitated. In addition, the substrate unit 20 can be fixed to the heat sink 25 using the spacer 54. Therefore, since it is not necessary to separately provide a fixing boss or the like for fixing the substrate unit 20 to the heat sink 25, an increase in the number of components can be suppressed, and a decrease in mounting areas of the electronic components on the first circuit substrate 21 and the second circuit substrate 22 can be suppressed.

In addition, the holding member 24 includes the first positioning protrusion 55 that is connected to the base portion 51, penetrates the first circuit substrate 21 in the axial direction, and is inserted into the heat sink 25, and the second positioning protrusion 56 that is connected to the base portion 51 and penetrates the second circuit substrate 22 in the axial direction.

According to this configuration, the first circuit substrate 21 and the second circuit substrate 22 can be positioned with respect to the heat sink 25 by the first positioning protrusion 55 and the second positioning protrusion 56. Therefore, the first circuit substrate 21 and the second circuit substrate 22 can be assembled to the heat sink 25 with higher accuracy.

In addition, the electronic component 28 is mounted on the first circuit substrate 21, and the thermal grease 29 is provided between the heat sink 25 and the electronic component 28. The holding member 24 further includes the load transmission portion 57 that is disposed at a position overlapping the thermal grease 29 in a plan view and abuts on the first circuit substrate 21 and the second circuit substrate 22.

According to this configuration, the load applied to the second circuit substrate 22 during manufacturing of the rotary electric machine 100 is transmitted to the first circuit substrate 21 via the load transmission portion 57, and thus the thermal grease 29 provided between the heat sink 25 and the electronic component 28 can be spread.

In addition, the motor 1 includes the rotor 12 that is fixed to the rotary shaft 11, the stator 13 that is disposed on an outer peripheral side of the rotor 12, the armature winding 15 that is wound around the stator 13, and the wiring terminal 17 that is electrically connected to the armature winding 15 and is connected to the first circuit substrate 21. The first circuit substrate 21 includes the motor terminal connection hole 32 to which the wiring terminal 17 is connected. The second circuit substrate 22 includes the cutout portion 43 that exposes the motor terminal connection hole 32 when the substrate unit 20 is viewed in the axial direction from the side of the second circuit substrate 22.

According to this configuration, for example, a connection tool for connecting the wiring terminal 17 to the motor terminal connection hole 32 can be brought close to a connection portion between the wiring terminal 17 and the motor terminal connection hole 32 through the cutout portion 43. Therefore, the connection between the wiring terminal 17 and the motor terminal connection hole 32 can be easily performed via the cutout portion 43. Therefore, the manufacturing of the rotary electric machine 100 is further facilitated.

In addition, the outer shape of the head portion of the fastening member 26 is substantially the same as the outer shape of the spacer 54 as viewed in the axial direction.

According to this configuration, the force generated when the fastening member 26 is fastened can be more reliably received by the spacer 54 while suppressing an increase in a space in which the head portion of the fastening member 26 is provided.

In addition, the control unit 2 further includes the connector assembly 27 including the press-fit terminal 74 that is connected to the first circuit substrate 21. The first circuit substrate 21 includes the connector terminal connection hole 35 that is provided at one end portion of the first circuit substrate 21 in the first direction D1 and to which the press-fit terminal 74 is connected. The length of the second circuit substrate 22 in the first direction D1 is shorter than the length of the first circuit substrate 21 in the first direction D1 such that the one end portion of the first circuit substrate 21 in the first direction D1 is exposed from the second circuit substrate 22 when the substrate unit 20 is viewed in the axial direction from the side of the second circuit substrate 22.

According to this configuration, the connector assembly 27 can be easily connected to the first circuit substrate 21 by using the press-fit terminal 74. Therefore, the manufacturing of the rotary electric machine 100 is further facilitated.

In addition, when the press-fit terminal 74 is connected to the connector terminal connection hole 35, the pressing force is applied to the one end portion of the first circuit substrate 21 in the first direction D1. Since the one end portion of the first circuit substrate 21 is exposed from the second circuit substrate 22, a receiving jig that supports the one end portion can be easily installed on the first circuit substrate 21. By receiving the pressing force applied to the first circuit substrate 21 by the receiving jig, the distortion of the first circuit substrate 21 can be suppressed. In addition, it is possible to prevent the poor connection of the press-fit terminal 74 due to the insufficient insertion amount of the press-fit terminal 74 into the connector terminal connection hole 35.

In addition, the connector assembly 27 includes the connector positioning protrusion 75 that is inserted through the first circuit substrate 21.

According to this configuration, since the connector assembly 27 is positioned with respect to the first circuit substrate 21 by the connector positioning protrusion 75, the press-fit terminal 74 can be more reliably connected to the connector terminal connection hole 35.

In addition, the tip of the connector positioning protrusion 75 is located on the side of the first circuit substrate 21 with respect to the tip of the press-fit terminal 74.

According to this configuration, the press-fit terminal 74 can be connected to the connector terminal connection hole 35 in a state where the connector assembly 27 is positioned with respect to the first circuit substrate 21 by the connector positioning protrusion 75. Therefore, the press-fit terminal 74 can be more reliably connected to the connector terminal connection hole 35.

In addition, the substrate unit 20 further includes the inter-substrate connector 23 that electrically connects the first circuit substrate 21 and the second circuit substrate 22.

According to this configuration, the first circuit substrate 21 and the second circuit substrate 22 can be easily electrically connected to each other by the inter-substrate connector 23.

### Second Embodiment.

Next, a rotary electric machine 100A according to a second embodiment will be described. Since a basic configuration of the rotary electric machine 100A according to the present embodiment is the same as that of the first embodiment, descriptions will focus on differences.

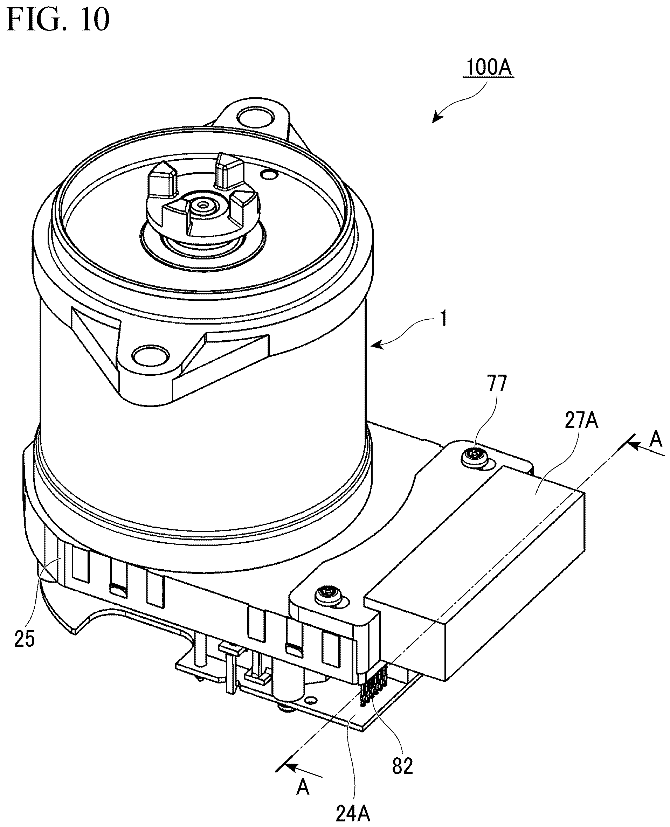

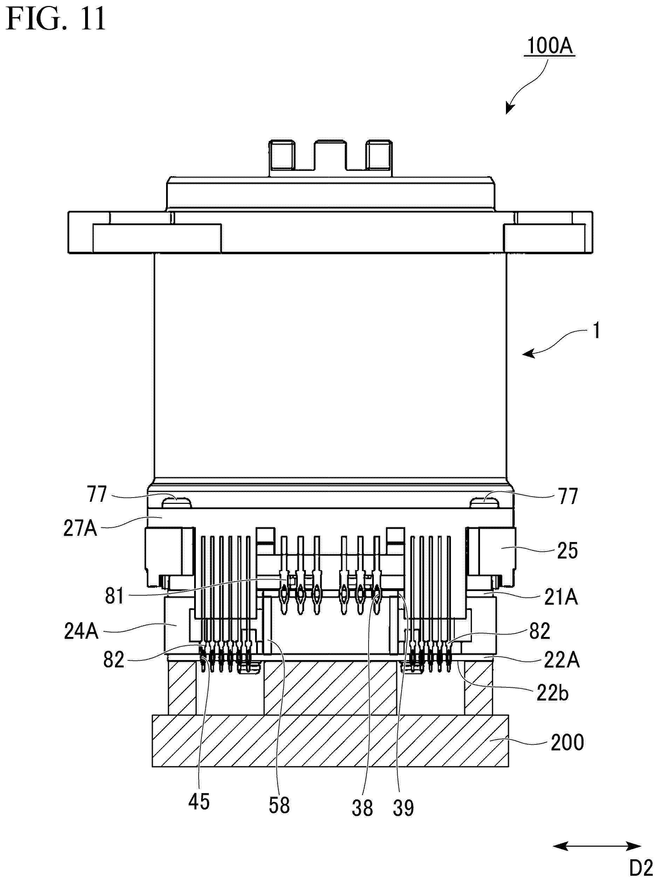

FIG. 10 is a perspective view of an intermediate structure of the rotary electric machine 100A as viewed from below. FIG. 11 is a cross-sectional view taken along line A-A of FIG. 10.

The present embodiment is different from the first embodiment in that a connector assembly 27A is connected to a first circuit substrate 21A and a second circuit substrate 22A.

As shown in FIGS. 10 and 11, the connector assembly 27A includes a first press-fit terminal 81 connected to the first circuit substrate 21A and a second press-fit terminal 82 connected to the second circuit substrate 22A, instead of the press-fit terminal 74.

The first press-fit terminals 81 are disposed at a center portion of the connector assembly 27A in the second direction D2. The second press-fit terminals 82 are disposed on both sides of the first press-fit terminals 81 in the second direction D2. A height of the second press-fit terminal 82 is greater than a height of the first press-fit terminal 81. That is, a tip of the second press-fit terminal 82 is located on the side of the second circuit substrate 22A with respect to a tip of the first press-fit terminal 81.

In the present embodiment, a length of the second circuit substrate 22A in the first direction D1 is substantially the same as a length of the first circuit substrate 21A in the first direction D1. In a plan view, the second circuit substrate 22A is provided to overlap one end portion of the first circuit substrate 21 in the first direction D1.

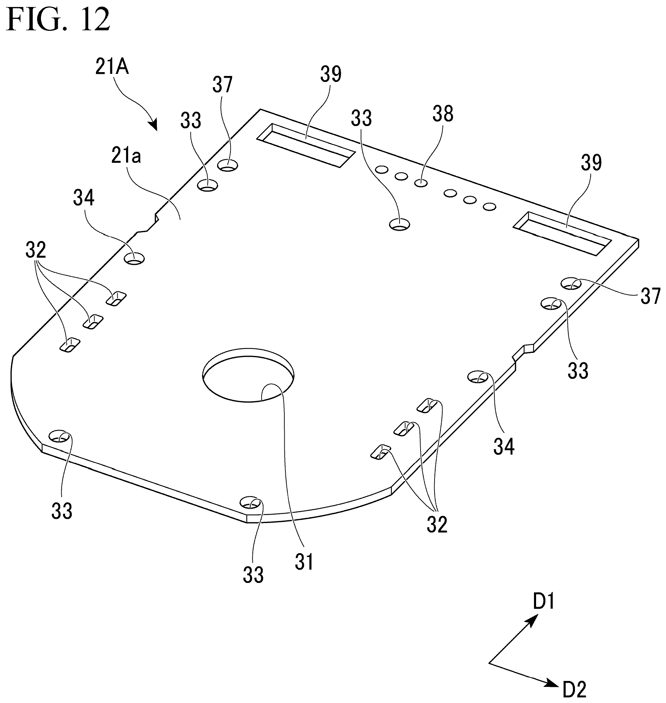

FIG. 12 is a perspective view of the first circuit substrate 21A from above. As shown in FIG. 12, the first circuit substrate 21A is provided with a first connector terminal connection hole 38 (first connector connection portion) to which the first press-fit terminal 81 is connected, instead of the connector terminal connection hole 35. The first connector terminal connection holes 38 are provided at the one end portion of the first circuit substrate 21A in the first direction D1. The first connector terminal connection holes 38 are disposed at a center portion of the first circuit substrate 21A in the second direction D2.

The first circuit substrate 21A is provided with a connector terminal through-hole 39 through which the second press-fit terminal 82 is inserted. The connector terminal through-hole 39 is provided at the one end portion of the first circuit substrate 21A in the first direction D1. The connector terminal through-holes 39 are disposed on both sides of the first connector terminal connection hole 38 in the second direction D2. In a plan view, a size of the connector terminal through-hole 39 is larger than a size of the second press-fit terminal 82. Therefore, in a case where the second press-fit terminal 82 is inserted through the connector terminal through-hole 39, the second press-fit terminal 82 and the connector terminal through-hole 39 are prevented from coming into contact with each other. A cutout portion for preventing the first circuit substrate 21A and the second press-fit terminals 82 from interfering with each other may be formed in the first circuit substrate 21A, instead of the connector terminal through-hole 39.

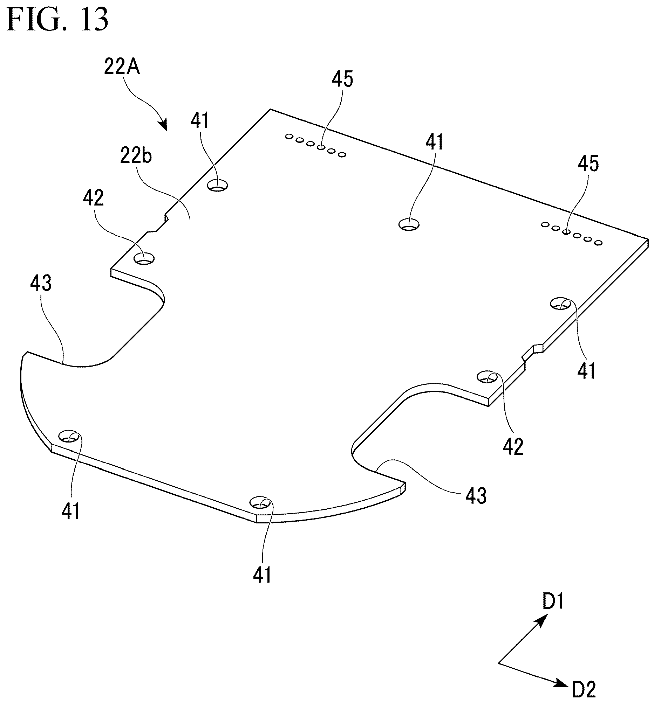

FIG. 13 is a perspective view of the second circuit substrate 22A from above. As shown in FIG. 13, the second circuit substrate 22A is provided with a second connector terminal connection hole 45 (second connector connection portion) to which the second press-fit terminal 82 is connected. The second connector terminal connection holes 45 are provided at one end portion of the second circuit substrate 22A in the first direction D1.

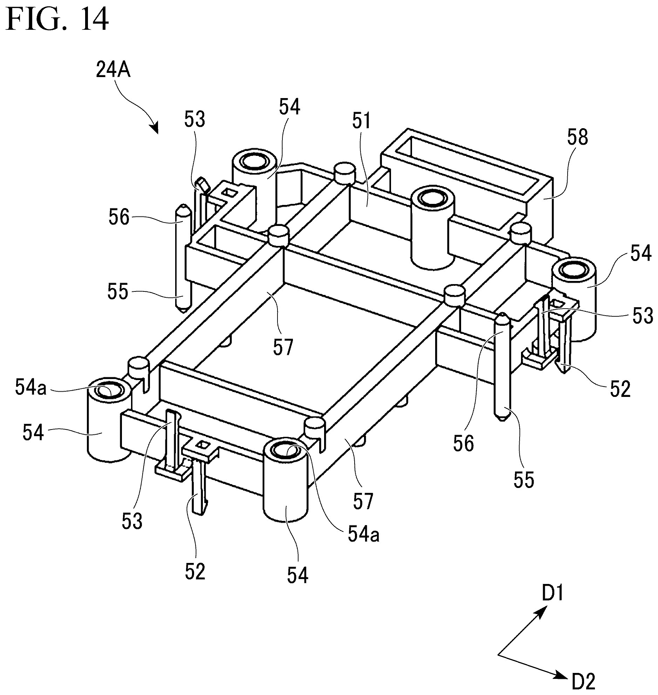

FIG. 14 is a perspective view of a holding member 24A from above. As shown in FIG. 14, in the present embodiment, the holding member 24A further includes a support portion 58. The support portion 58 has a frame shape having an inner space. The support portion 58 is connected to one end portion of the base portion 51 in the first direction D1. The support portion 58 abuts on the first circuit substrate 21A and the second circuit substrate 22A. The support portion 58 is provided to surround the first connector terminal connection holes 38 of the first circuit substrate 21A in a plan view. The support portion 58 supports a periphery of the first connector terminal connection hole 38 in the first circuit substrate 21A. A tip of the first press-fit terminal 81 connected to the first connector terminal connection hole 38 is accommodated in the inner space of the support portion 58. As a result, the first press-fit terminal 81 and the holding member 24A are prevented from coming into contact with each other.

In a method for manufacturing the rotary electric machine 100A according to the present embodiment, in the connector attaching step, the connector assembly 27A is connected to the first circuit substrate 21A and the second circuit substrate 22A. Since the other steps (the substrate unit assembling step, the substrate unit fixing step, and the cover attaching step) are the same as those in the first embodiment, the description thereof will be omitted here.

In the connector attaching step, first, an intermediate structure of the rotary electric machine 100A after the substrate unit fixing step is turned upside down. The connector assembly 27A is caused to face the second surface 21b of the first circuit substrate 21A. The connector positioning protrusions 75 are inserted through the connector positioning through-holes 37 of the first circuit substrate 21A. At this time, the second press-fit terminals 82 are inserted through the connector terminal through-holes 39 of the first circuit substrate 21A. A receiving jig 200 is installed on the fourth surface 22b of the second circuit substrate 22A. A load is applied to the connector assembly 27A toward the first circuit substrate 21A. Accordingly, the first press-fit terminals 81 are press-fitted into the first connector terminal connection holes 38 of the first circuit substrate 21A, and the second press-fit terminals 82 are press-fitted into the second connector terminal connection holes 45 of the second circuit substrate 22A.

Here, when the first press-fit terminal 81 is press-fitted into the first connector terminal connection hole 38, a pressing force is applied to the first circuit substrate 21A. In addition, when the second press-fit terminal 82 is press-fitted into the second connector terminal connection hole 45, a pressing force is applied to the second circuit substrate 22A. In the present embodiment, the support portion 58 is provided to surround the first connector terminal connection hole 38 between the first circuit substrate 21 A and the second circuit substrate 22A. Therefore, the periphery of the first connector terminal connection hole 38 in the first circuit substrate 21A is supported by the support portion 58. In addition, the receiving jig 200 is provided on the fourth surface 22b of the second circuit substrate 22A. As a result, the pressing force applied to the first circuit substrate 21A can be received by the receiving jig 200 via the support portion 58. In addition, the pressing force applied to the second circuit substrate 22A can be received by the receiving jig 200. Therefore, distortion of the first circuit substrate 21A can be suppressed, and poor connection of the first press-fit terminal 81 due to an insufficient insertion amount of the first press-fit terminal 81 into the first connector terminal connection hole 38 can be prevented. In addition, distortion of the second circuit substrate 22A can be suppressed, and poor connection of the second press-fit terminal 82 due to an insufficient insertion amount of the second press-fit terminal 82 into the second connector terminal connection hole 45 can be prevented.

Then, the connector assembly 27A is screwed and fixed to the heat sink 25 by the second fastening members 77.

As described above, in the rotary electric machine 100A according to the present embodiment, the connector assembly 27A further includes the second press-fit terminal 82 that is connected to the second circuit substrate 22A. The second circuit substrate 22A includes the second connector terminal connection hole 45 that is provided at one end portion of the second circuit substrate 22A in the first direction D1 and to which the second press-fit terminal 82 is connected. The holding member 24A further includes the support portion 58 that is provided to surround the first connector terminal connection hole 38 as viewed in the axial direction and abuts on the first circuit substrate 21A and the second circuit substrate 22A.

According to this configuration, a signal or the like from the external sensor can be directly input from the connector assembly 27A to the second circuit substrate 22A. It is not necessary to provide, in the inter-substrate connector 23, a terminal or the like for transmitting the signal or the like from the first circuit substrate 21A to the second circuit substrate 22A, and thus the inter-substrate connector 23 can be reduced in size. Therefore, the mounting areas of the electronic components on the first circuit substrate 21A and the second circuit substrate 22A can be increased.

In addition, the support portion 58 supports the periphery of the first connector terminal connection hole 38 in the first circuit substrate 21A. When the first press-fit terminal 81 and the second press-fit terminal 82 are connected to the first connector terminal connection hole 38 and the second connector terminal connection hole 45, respectively, the pressing force is applied to the first circuit substrate 21A and the second circuit substrate 22A. Since the pressing force can be received by the support portion 58, the distortion of the first circuit substrate 21A and the second circuit substrate 22A can be suppressed. In addition, it is possible to prevent the poor connection of the first press-fit terminal 81 due to an insufficient insertion amount of the first press-fit terminal 81 into the first connector terminal connection hole 38 and the poor connection of the second press-fit terminal 82 due to an insufficient insertion amount of the second press-fit terminal 82 into the second connector terminal connection hole 45.

### Modification Example of Second Embodiment.

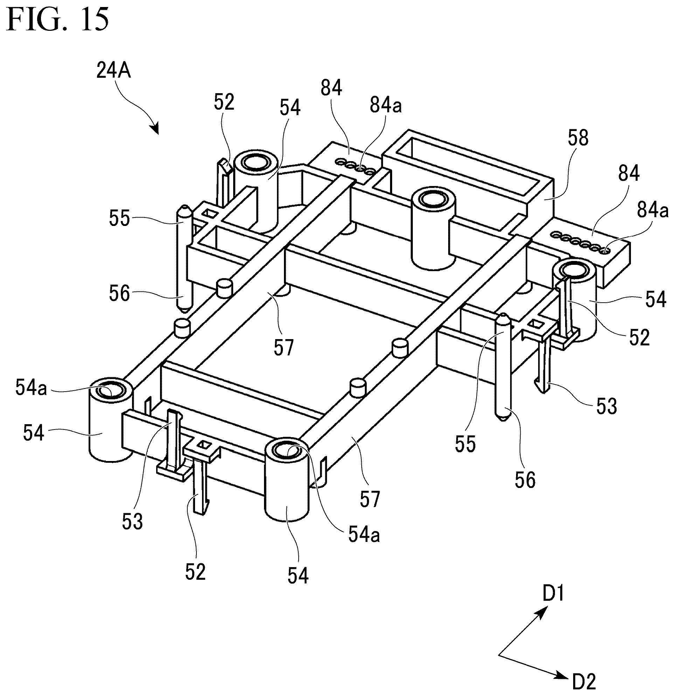

FIG. 15 is a perspective view of the holding member 24A according to a modification example of the second embodiment from below.

In the present modification example, the holding member 24A further includes a guide portion 84. The guide portion 84 has a guide through-hole 84a that penetrates the guide portion 84 in the axial direction. The plurality of guide through-holes 84a are disposed at positions overlapping a plurality of the second connector terminal connection holes 45 in a plan view. A lower end portion (end portion on one side) of the guide through-hole 84a is formed in a tapered shape that gradually increases in diameter toward the lower side (one side).

In the connector attaching step, the second press-fit terminal 82 is inserted into the guide through-hole 84a from below (one side). Since the lower end portion of the guide through-hole 84a is formed in a tapered shape, the second press-fit terminal 82 can be smoothly inserted into the guide through-hole 84a. The second press-fit terminal 82 is guided by the guide through-hole 84a toward the second connector terminal connection hole 45 and is press-fitted into the second connector terminal connection hole 45.

In a plan view, a size of the guide through-hole 84a is larger than the size of the second press-fit terminal 82. Therefore, when the second press-fit terminal 82 is inserted through the guide through-hole 84a, the second press-fit terminal 82 and the guide through-hole 84a are prevented from coming into contact with each other.

As described above, the holding member 24A according to the present modification example includes the guide portion 84 having the guide through-hole 84a through which the second press-fit terminal 82 is inserted from one side. The end portion of the guide through-hole 84a on the one side is formed in a tapered shape.

According to this configuration, the second press-fit terminal 82 is guided by the guide portion 84 toward the second connector terminal connection hole 45, so that deviation between a position of the second press-fit terminal 82 and a position of the second connector terminal connection hole 45 can be prevented. Accordingly, the second press-fit terminal 82 can be reliably inserted into the second connector terminal connection hole 45. In addition, buckling of the second press-fit terminal 82, damage to the second connector terminal connection hole 45, and the like caused by the deviation between the position of the second press-fit terminal 82 and the position of the second connector terminal connection hole 45 can be prevented. In addition, since the end portion of the guide through-hole 84a on the one side is formed in a tapered shape, the second press-fit terminal 82 can be smoothly inserted into the guide through-hole 84a. Therefore, it is possible to improve reliability of a connection portion of the second press-fit terminal 82 without increasing the number of components.

### Third Embodiment.

Next, a rotary electric machine 100B according to a third embodiment will be described. Since a basic configuration of the rotary electric machine 100B according to the present embodiment is the same as that of the first embodiment, descriptions will focus on differences.

The third embodiment is different from the first embodiment in that the control unit 2 further includes a third circuit substrate 91, a second holding member 92, and a second inter-substrate connector 93. A substrate unit 20A is constituted by the first circuit substrate 21, the second circuit substrate 22, the inter-substrate connector 23, the holding member 24, the third circuit substrate 91, the second holding member 92, and the second inter-substrate connector 93.

The third circuit substrate 91 is disposed above the second circuit substrate 22. The second inter-substrate connector 93 is disposed between the second circuit substrate 22 and the third circuit substrate 91 in the axial direction. The second inter-substrate connector 93 electrically connects the second circuit substrate 22 and the third circuit substrate 91.

In the present embodiment, the second positioning protrusion 56 of the holding member 24 penetrates the second circuit substrate 22 and the third circuit substrate 91 in the axial direction. The second circuit substrate 22 and the third circuit substrate 91 are positioned with respect to the holding member 24 by the second positioning protrusions 56.

The second holding member 92 is disposed between the second circuit substrate 22 and the third circuit substrate 91 in the axial direction. The second holding member 92 holds the second circuit substrate 22 and the third circuit substrate 91. Similar to the holding member 24 according to the first embodiment, the second holding member 92 includes a third locking portion (not shown) that locks the second circuit substrate 22 from the third surface 22a of the second circuit substrate 22, and a fourth locking portion (not shown) that locks the third circuit substrate 91 from an upper surface of the third circuit substrate 91.

The second holding member 92 includes a second spacer 92a and a second load transmission portion 92b.

The second spacer 92a has a cylindrical shape that extends in the axial direction. A plurality of the second spacers 92a are disposed at positions overlapping the plurality of spacers 54 in a plan view. One end of the second spacer 92a in the axial direction abuts on the second circuit substrate 22, and the other end of the second spacer 92a in the axial direction abuts on the third circuit substrate 91. The second spacer 92a secures an interval between the second circuit substrate 22 and the third circuit substrate 91. The second spacer 92a has a fourth fastening through-hole that penetrates the second spacer 92a in the axial direction. The fastening member 26 is inserted through the fourth fastening through-hole.

The second load transmission portion 92b is disposed at a position overlapping the thermal grease 29 in a plan view. The second load transmission portion 92b abuts on the second circuit substrate 22 and the third circuit substrate 91. A load applied to the third circuit substrate 91 during manufacturing of the rotary electric machine 100 is transmitted to the first circuit substrate 21 via the second load transmission portion 92b, the second circuit substrate 22, and the load transmission portion 57. As a result, the first circuit substrate 21 is pressed against the heat sink 25, and the thermal grease 29 applied between the heat sink 25 and the electronic component 28 mounted on the first circuit substrate 21 is spread.

In a method for manufacturing the rotary electric machine 100B according to the present embodiment, in the substrate unit assembling step, the substrate unit 20A is assembled by holding the first circuit substrate 21, the second circuit substrate 22, and the third circuit substrate 91 by the holding member 24 and the second holding member 92. In this case, since the second circuit substrate 22 and the third circuit substrate 91 are positioned with respect to the holding member 24 by the second positioning protrusions 56, the substrate unit 20A can be assembled with the same accuracy as in the first embodiment.

Since the other steps (the substrate unit assembling step, the connector attaching step, and the cover attaching step) are the same as those in the first embodiment, the description thereof will be omitted here.

As described above, in the rotary electric machine 100B according to the present embodiment, the substrate unit 20A further includes the third circuit substrate 91, and the second holding member 92 that is disposed between the second circuit substrate 22 and the third circuit substrate 91 and holds the second circuit substrate 22 and the third circuit substrate 91.

According to this configuration, even in a case where the number of circuit substrates in the control unit 2 is increased, the same effect as that of the first embodiment can be obtained. That is, the substrate unit 20A is assembled by holding the first circuit substrate 21, the second circuit substrate 22, and the third circuit substrate 91 by the holding member 24 and the second holding member 92. Thereafter, the substrate unit 20A is fixed to the heat sink 25 by the fastening member 26, so that the first circuit substrate 21, the second circuit substrate 22, and the third circuit substrate 91 can be assembled to the heat sink 25 at once and with high accuracy. Since it is not necessary to assemble the circuit substrates 21, 22, and 91 one by one, the manufacturing of the rotary electric machine 100B is facilitated. In addition, since a manufacturing line of the rotary electric machine 100B can be shared with a manufacturing line of a rotary electric machine in which a control unit is constituted by one circuit substrate, the manufacturing cost can be reduced.

Even in a case where the number of circuit substrates in the control unit 2 is four or more, the same effect can be obtained.

The embodiments can be combined, and each embodiment can be modified or omitted as appropriate.

The heat sink 25 may be formed integrally with the motor case 14 of the rotary electric machine 100.

For example, the fastening member 26 is not limited to a screw as long as the substrate unit 20 can be fixed to the heat sink 25.

The number and disposition of the fastening members 26, the first locking portions 52, the second locking portions 53, the spacers 54, the first positioning protrusions 55, and the second positioning protrusions 56 of the holding member 24, the press-fit terminals 74 of the connector assembly 27, and the like may be appropriately changed according to specifications of the rotary electric machine 100.

### Reference Signs List

1 Motor
2 Control unit
11 Rotary shaft
12 Rotor
13 Stator
15 Armature winding
16 Annular wiring portion
17 Wiring terminal
20, 20A Substrate unit
21, 21A First circuit substrate
22, 22A Second circuit substrate
23 Inter-substrate connector
24, 24A Holding member
25 Heat sink
26 Fastening member
27, 27A Connector assembly
28 Electronic component
29 Thermal grease
32 Motor terminal connection hole (motor connection portion)
35 Connector terminal connection hole (first connector connection portion)
38 First connector terminal connection hole (first connector connection portion)
39 Connector terminal through-hole
43 Cutout portion
45 Second connector terminal connection hole (second connector connection portion)
51 Base portion
52 First locking portion
53 Second locking portion
54 Spacer
55 First positioning protrusion
56 Second positioning protrusion
57 Load transmission portion
58 Support portion
74 Press-fit terminal (first press-fit terminal)
75 Connector positioning protrusion
81 First press-fit terminal
82 Second press-fit terminal
84 Guide portion
84a Guide through-hole
91 Third circuit substrate
92 Second holding member
100, 100A, 100B Rotary electric machine

## Claims

1. A rotary electric machine comprising:
a motor including a rotary shaft; and
a control unit configured to control the motor,
wherein the control unit includes:
a substrate unit that includes a first circuit substrate, a second circuit substrate, and a holding member that is disposed between the first circuit substrate and the second circuit substrate and holds the first circuit substrate and the second circuit substrate;
a heat sink that is disposed between the motor and the substrate unit and faces the first circuit substrate in an axial direction of the rotary shaft; and
a fastening member that fixes the substrate unit to the heat sink,
the holding member includes:
a base portion;
a first locking portion that is connected to the base portion and locks the first circuit substrate from a second surface of the first circuit substrate on a side opposite to a first surface of the first circuit substrate facing the base portion; and
a second locking portion that is connected to the base portion and locks the second circuit substrate from a fourth surface of the second circuit substrate on a side opposite to a third surface of the second circuit substrate facing the base portion, and
the fastening member penetrates the substrate unit in the axial direction and is fastened to the heat sink.

2. The rotary electric machine according to Claim 1,
wherein the holding member further includes a spacer that is connected to the base portion, extends in the axial direction, and abuts on the first circuit substrate and the second circuit substrate, and
the fastening member is inserted through the spacer.

3. The rotary electric machine according to Claim 1 or 2,
wherein the holding member includes:
a first positioning protrusion that is connected to the base portion, penetrates the first circuit substrate in the axial direction, and is inserted into the heat sink; and
a second positioning protrusion that is connected to the base portion and penetrates the second circuit substrate in the axial direction.

4. The rotary electric machine according to any one of Claims 1 to 3,
wherein an electronic component is mounted on the first circuit substrate,
a thermal grease is provided between the heat sink and the electronic component, and
the holding member further includes a load transmission portion that is disposed at a position overlapping the thermal grease as viewed in the axial direction and abuts on the first circuit substrate and the second circuit substrate.

5. The rotary electric machine according to any one of Claims 1 to 4,
wherein the motor includes a rotor that is fixed to the rotary shaft, a stator that is disposed on an outer peripheral side of the rotor, an armature winding that is wound around the stator, and a wiring terminal that is electrically connected to the armature winding and is connected to the first circuit substrate,
the first circuit substrate includes a motor connection portion to which the wiring terminal is connected, and
the second circuit substrate includes a cutout portion that exposes the motor connection portion when the substrate unit is viewed in the axial direction from a side of the second circuit substrate.

6. The rotary electric machine according to Claim 2,
wherein an outer shape of a head portion of the fastening member is substantially the same as an outer shape of the spacer as viewed in the axial direction.

7. The rotary electric machine according to any one of Claims 1 to 6,
wherein the control unit further includes a connector assembly including a first press-fit terminal that is connected to the first circuit substrate,
the first circuit substrate includes a first connector connection portion that is provided at one end portion of the first circuit substrate in a first direction orthogonal to the axial direction and to which the first press-fit terminal is connected, and
a length of the second circuit substrate in the first direction is shorter than a length of the first circuit substrate in the first direction such that the one end portion of the first circuit substrate in the first direction is exposed from the second circuit substrate when the substrate unit is viewed in the axial direction from a side of the second circuit substrate.

8. The rotary electric machine according to Claim 7,
wherein the connector assembly further includes a second press-fit terminal that is connected to the second circuit substrate,
the second circuit substrate includes a second connector connection portion that is provided at one end portion of the second circuit substrate in the first direction and to which the second press-fit terminal is connected, and
the holding member further includes a support portion that is provided to surround the first connector connection portion as viewed in the axial direction and abuts on the first circuit substrate and the second circuit substrate.

9. The rotary electric machine according to Claim 8,
wherein the holding member includes a guide portion having a guide through-hole through which the second press-fit terminal is inserted from one side, and
an end portion of the guide through-hole on the one side is formed in a tapered shape.

10. The rotary electric machine according to any one of Claims 7 to 9,
wherein the connector assembly includes a connector positioning protrusion that is inserted through the first circuit substrate.

11. The rotary electric machine according to Claim 10,
wherein a tip of the connector positioning protrusion is located on a side of the first circuit substrate with respect to a tip of the first press-fit terminal.

12. The rotary electric machine according to any one of Claims 1 to 11,
wherein the substrate unit further includes a third circuit substrate, and a second holding member that is disposed between the second circuit substrate and the third circuit substrate and holds the second circuit substrate and the third circuit substrate.

13. The rotary electric machine according to any one of Claims 1 to 12,
wherein the substrate unit further includes an inter-substrate connector that electrically connects the first circuit substrate and the second circuit substrate.

14. A method for manufacturing a rotary electric machine, the method comprising:
a substrate unit assembling step of assembling a substrate unit by holding a first circuit substrate and a second circuit substrate by a holding member; and
a substrate unit fixing step of fixing the substrate unit to a heat sink by causing a fastening member to penetrate the substrate unit in an axial direction of a rotary shaft of a motor and fastening the fastening member to the heat sink.
